# EUROPEAN PATENT APPLICATION

(11) **EP 4 518 068 A1**
(43) Date of publication of application: **05.03.2025**
(21) Application number: 23795267.6
(22) Date of filing: 23.04.2023
(51) Int. Cl.: H02H 3/34, H02H 3/05, H02H 3/04, G01R 31/52

(54) **RESIDUAL CURRENT OPERATED CIRCUIT-BREAKER**

(30) Priority: 24.04.2022 CN 202210435816
(71) Applicant: Zhejiang Chint Electrics Co., Ltd., Yueqing, Zhejiang 325603 (CN)
(72) Inventor: WANG, Bangle, Wenzhou, Zhejiang 325603 (CN); CAI, Youfeng, Wenzhou, Zhejiang 325603 (CN); YAO, Xifeng, Wenzhou, Zhejiang 325603 (CN); SHI, Jianxin, Wenzhou, Zhejiang 325603 (CN); ZHUO, Li, Wenzhou, Zhejiang 325603 (CN); YIN, Gang, Wenzhou, Zhejiang 325603 (CN); LUO, Zhi, Wenzhou, Zhejiang 325603 (CN); YAN, Gang, Wenzhou, Zhejiang 325603 (CN); FANG, Sufang, Wenzhou, Zhejiang 325603 (CN)
(74) Representative: Petraz, Gilberto Luigi
(86) International application number: PCT/CN2023/090031
(87) International publication number: WO 2023/207834

(57) **Abstract**

A residual current operated circuit breaker includes a residual current transformer, an excitation oscillation circuit, an integrating circuit and a main control circuit, wherein the excitation oscillation circuit is connected to an excitation winding on the residual current transformer; the integrating circuit is used for transforming an excitation square wave signal produced by the excitation oscillation circuit into a triangular wave signal and then outputting the triangular wave signal respectively through a first output terminal and a second output terminal; the first output terminal is connected to the main control circuit through a filtering and amplification circuit; the second output terminal is directly connected to the main control circuit; the main control circuit collects a residual current of the filter and amplification circuit and/or the second output terminal respectively, and is used for controlling the residual current operated circuit breaker to be disconnected, thereby not only being capable of processing the magnitude of the residual current, but also reducing the use of a hardware circuit.

## Description

### TECHNICAL FIELD

The present invention relates to the field of low-voltage electrical appliances, in particular to a residual current operated circuit breaker.

### BACKGROUND

With the swift advancement of the new energy sector, the current AC and A-type residual current protective devices are no longer adequate to safeguard the residual currents across various load types. There is an urgent need for a comprehensive residual current protection device capable of handling AC, pulsating DC, smooth DC, composite currents, and high-frequency currents. However, the rated current of existing devices on the market typically does not exceed 63A, and the rated residual current is usually capped at 300mA. As the capacity of charging piles increases, these devices are insufficient for large-scale photovoltaic power generation and electric vehicle charging systems, which require higher rated currents and residual currents to serve as the main switch in new energy distribution systems. Yet, the sampling accuracy of current residual current protective devices is subpar. The expansion and adjustability of the rated residual current range have led to a decline in sampling precision and an increase in costs.

### SUMMARY

An object of the present invention is to overcome the defects of the prior art, and to provide a residual current operated circuit breaker which has a rated current and a rated residual current that satisfy the use in a new energy power distribution system.

In order to achieve the above object, the present invention adopts the following technical solutions:
A residual current operated circuit breaker, comprising a power supply circuit, a sampling circuit and a main control circuit, wherein the power supply circuit supplies power to the sampling circuit and the main control circuit; the main control circuit collects a residual current of a main circuit of the circuit breaker through the sampling circuit; the sampling circuit comprises an excitation oscillation circuit and an integrating circuit; the excitation oscillation circuit is connected to an excitation winding on the residual current transformer; the integrating circuit is used for transforming an excitation square wave signal produced by the excitation oscillation circuit into a triangular wave signal and then outputting the triangular wave signal respectively through a first output terminal and a second output terminal; the first output terminal is connected to the main control circuit through a filtering and amplification circuit; the second output terminal is directly connected to the main control circuit; and the main control circuit collects a residual current of the filter and amplification circuit and/or the second output terminal respectively, and used for controlling the residual current operated circuit breaker to be disconnected.

Preferably, further comprising a residual current gear selection circuit and a delay gear selection circuit which are respectively connected to the main control circuit, wherein the residual current gear selection circuit is used for outputting a plurality of different signals to the main control circuit to set an action threshold of the magnitude of the residual current; and the delay gear selection circuit is used for outputting a plurality of different signals to the main control circuit to set a delay threshold of the residual current.

Preferably, the main control circuit performs FIR or Kalman digital filtering processing on the second output terminal.

Preferably, the integrating circuit comprises an operational amplifier U6B, and a high-pass filtering circuit and an RC integrating circuit that are respectively connected to an input terminal of the operational amplifier U6B; an output terminal of the operational amplifier U6B is connected to the filtering and amplification circuit and the main control circuit, respectively; the high-pass filtering circuit is connected to the excitation oscillation circuit; the high-pass filtering circuit is used for filtering a duty cycle signal outputted from the excitation oscillation circuit; the RC integrating circuit is used for transforming the filtered signal into a triangular wave signal; and the operational amplifier U6B is used as a voltage follower to increase a later-stage driving capability of a triangular wave signal at a non-inverting input terminal.

Preferably, the excitation oscillation circuit includes a square wave impulse voltage driving circuit and a comparison circuit; and the square wave impulse voltage driving circuit and the comparison circuit are connected to an excitation winding on the residual current transformer, and used for forming cyclic self-excited oscillation.

Preferably, the filtering and amplification circuit comprises a fourth-order filtering circuit consisting of two second-order Butterworth active filtering circuits which are connected in series.

Preferably, further comprising a zeroing circuit connected to the filtering and amplification circuit.

Preferably, the two second-order Butterworth active filtering circuits both include an operational amplifier, wherein the operational amplifier of one of the second-order Butterworth active filtering circuits is connected to an zeroing circuit; the zeroing circuit comprises a resistor R60 and a resistor R63 connected between a voltage VCC and a grounding terminal; the resistor R60 and the resistor R63 are connected in series; and a connection point between the resistor R60 and the resistor R63 is connected to a non-inverting input terminal of the operational amplifier of the second-order Butterworth active filter circuit.

Preferably, the excitation oscillation circuit comprises a comparator U5B, an NPN triode Q4 and a PNP triode Q6; a collector of the NPN triode Q4 is connected to the voltage VCC, and an emitter of the NPN triode Q4 is connected to an emitter of the PNP triode Q6; a collector of the PNP triode Q6 is grounded; a connection point between the emitter of the NPN triode Q4 and the emitter of the PNP triode Q6 is connected to one end of the excitation winding on the residual current transformer; an inverting input terminal of the comparator U5B is connected to a reference voltage Vref through a resistor R1 and a resistor R5; a connection point between the resistor R1 and the resistor R5 is connected to the other end of the excitation winding; a bidirectional voltage regulator diode D6 is connected in parallel to both ends of the excitation winding; a positive input terminal of the comparator U5B is connected to the reference voltage Vref through a resistor R2; one end of the resistor R4 connected in parallel to the capacitor C20 is connected in parallel to the output terminal of the comparator U5B, and the other end of the resistor R4 is connected to a base of the NPN triode Q4 and a base of the PNP transistor Q6; the output terminal of the comparator U5B is connected to the positive input terminal of the comparator U5B through a resistor R3, and is outputted to the main control circuit.

Preferably, the excitation oscillation circuit comprises a comparator U5B; an output terminal of the comparator U5B is connected to one end of the excitation winding on the residual current transformer; an inverting input terminal of the comparator U5B is connected to a reference voltage Vref through a resistor R28, a resistor R35 and a resistor R40, and the other end of the excitation winding is connected between the resistor R28 and the resistor R35; a positive input terminal of the comparator U5B is connected to the reference voltage Vref through a resistor R38; an output terminal of the comparator U5B is connected to a positive input terminal of the comparator U5B through a resistor R36, and outputted to the main control circuit; the bidirectional voltage regulator diode D6 is connected in parallel to both ends of the excitation winding; and one end of the capacitor C23 is grounded, and the other end of the capacitor C23 is connected between the resistor R35 and the resistor R40.

Preferably, the power supply circuit comprises a first BUCK circuit and a second BUCK circuit; the first BUCK circuit is used for supplying a voltage VCC to a sampling circuit; the second BUCK circuit is used for supplying a voltage VDD to the main control circuit; the voltage VCC is greater than the voltage VDD; the residual current operated circuit breaker further comprises a power supply monitoring circuit connected to the main control circuit; and the power supply monitoring circuit monitors the voltage VCC used for supplying power to the sampling circuit and the voltage VDD used for supplying power to the main control circuit, and the power supply monitoring circuit outputs a monitoring signal to the main control circuit.

Preferably, the power supply monitoring circuit comprises a hysteresis comparison circuit, wherein the hysteresis comparison circuit is used for comparing a power supply Vin obtained by voltage division of a voltage VCC with a voltage VDD, and outputting a low level to the main control circuit when the power supply Vin is less than the voltage VDD, such that the main control circuit cannot output a tripping signal, and output a high level to the main control circuit when the power supply Vin is greater than the voltage VDD.

Preferably, the power supply monitoring circuit comprises a comparator U3B; an output terminal of the comparator U3B is connected to the main control circuit; an inverting input terminal of the comparator U3B is connected to the voltage VDD, and a non-inverting input terminal of the comparator U3B is connected to nodes constituting the power supply Vin through a resistor R8; and the nodes constituting the power supply Vin are connected to the voltage VCC and the ground terminal through a resistor R6 and a resistor R7, respectively.

According to the residual current operated circuit breaker of the present invention, an output signal of the integrating circuit is divided into two paths of signals by the first output terminal and the second output terminal and then processed, wherein one path passes through the hardware filtering and amplification circuit and is then used as an ADC input of the main control circuit and used for processing, for example, a small residual current signal of 0.1A and below, and the other path is directly used as the ADC input of the main control circuit. The main control circuit may be subjected to digital filtering so as to filter out a carrier component of a triangle wave. The characteristics of a fundamental residual current in a main circuit are restored to process a large residual current signal of above 0.1A. Therefore, the accuracy of the residual current of sampling can be improved, the large and small residual currents can be processed, and the use of the hardware circuit can also be reduced.

In addition, the residual current operated circuit breaker further includes a power supply monitoring circuit connected to the main control circuit. This power supply monitoring circuit monitors the voltage VCC, which powers the sampling circuit, and the voltage VDD, which powers the main control circuit, outputting a monitoring signal to the main control circuit. The main control circuit can only drive the residual current operated circuit breaker to disconnect when the voltage VCC is stable and the residual current magnitude and duration meet the action criteria. Therefore, during the power-on and power-down processes, the instability in the residual current sampling of the main control circuit caused by the instability of the voltage VCC is prevented, which in turn prevents the main control circuit from accidentally triggering the product action.

### BRIEF DESCRIPTION OF THE DRAWINGS

FIG. 1 is a principle block diagram of a residual current operated circuit breaker of the present invention;
FIG. 2 is an excitation voltage oscillogram of an excitation winding in the absence of a residual current;
FIG. 3 is an excitation voltage oscillogram of the excitation winding in the presence of a residual current;
FIG. 4 is an excitation current oscillogram of the excitation winding in the absence of a residual current;
FIG. 5 is an excitation current oscillogram of the excitation winding in the presence of a residual current;
FIG. 6 is an oscillogram after integral transformation of a waveform in FIG. 2 in the absence of a residual current;
FIG. 7 is an oscillogram after integral transformation of a waveform in FIG. 3 in the presence of a residual current;
FIG. 8 is an oscillogram after active filtering of a waveform in FIG. 6 in the absence of a residual current;
FIG. 9 is an oscillogram after active filtering of a waveform in FIG. 7 in the presence of a residual current;
FIG. 10 is a timing diagram of power-on and power-down processes of a voltage VCC, a voltage VDD and an ADC input on a main control circuit in the present invention;
FIG. 11 is a circuit diagram of a power supply monitoring circuit in the present invention;
FIG. 12 shows power-on and power-down processes of the voltage VDD in the present invention;
FIG. 13 is a circuit diagram of an excitation oscillation circuit in the present invention;
FIG. 14 is a circuit diagram of another implementation mode of excitation oscillation in the present invention;
FIG. 15 is a circuit diagram of a residual current testing circuit in the present invention;
FIG. 16 is a circuit diagram of detection of a residual current testing key in the present invention;
FIG. 17 is a circuit diagram of a tripping control circuit in the present invention;
FIG. 18 is an implementation flowchart in the present invention;
FIG. 19 shows a residual current gear selection circuit and a delay gear selection circuit in the present invention;
FIG. 20 is a circuit diagram of an integrating circuit in the present invention;
FIG. 21 is a circuit diagram of a filtering and amplification circuit and a zeroing circuit in the present invention;
FIG. 22 is a circuit diagram of a rectifying circuit in the present invention;
FIG. 23 is a circuit diagram of a BUCK circuit in the present invention;
FIG. 24 is a circuit diagram of a DC-DC BUCK circuit in the present invention;
FIG. 25 is a circuit diagram of a first BUCK circuit in the present invention; and
FIG. 26 is a circuit diagram of the second BUCK circuit in the present invention.

### DETAILED DESCRIPTION OF THE INVENTION

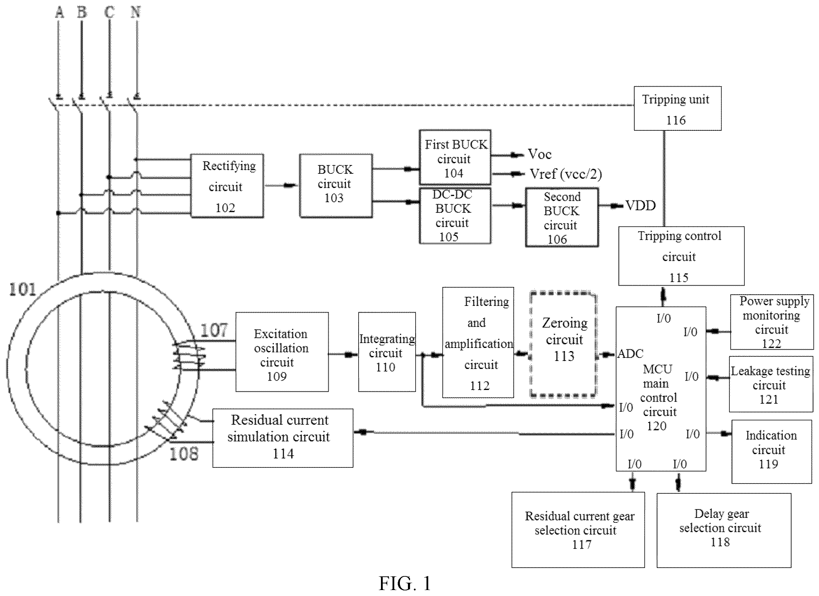

The specific implementation of a residual current operated circuit breaker of the present invention will be further described below with reference to the embodiments given in FIGS. 1 to 26. The residual current operated circuit breaker in the present invention is not limited to the description of the following embodiments.

As shown in FIG. 1, the residual current operated circuit breaker of the present invention includes a residual current transformer 101, an excitation oscillation circuit 109, an integrating circuit 110 and a main control circuit 120. The excitation oscillation circuit 109 is connected to an excitation winding 107 on the residual current transformer. The integrating circuit 110 is used for transforming an excitation square wave signal generated by the excitation oscillation circuit 109 into a triangular wave signal and then outputting the triangular wave signal respectively through a first output terminal and a second output terminal. The first output terminal is connected to the main control circuit 120 through a filtering and amplification circuit 112. The second output terminal is directly connected to the main control circuit 120. The second output terminal is subjected to digital filtering through the main control circuit 120. The main control circuit 120 collects a residual current of the filtering and amplification circuit 112 and/or the second output terminal respectively, and used for controlling the residual current operated circuit breaker to be disconnected. The main control circuit 120 determines a magnitude and duration of the residual current respectively according to the first output terminal and the second output terminal of the integrating circuit 110, and drives the residual current operated circuit breaker to be disconnected when an action condition is satisfied.

According to the residual current operated circuit breaker of the present invention, an output signal of the integrating circuit 110 is divided into two signal paths, which are then processed by the first output terminal and the second output terminal, wherein one path passes through the hardware filtering and amplification circuit 112 and is then used as an ADC input of the main control circuit 120 and used for processing, for example, a small residual current signal of 0.1A and below, and the other path is directly used as the ADC input of the main control circuit 120. The main control circuit 120 may be subjected to digital filtering so as to filter out a carrier component of a triangle wave. The characteristics of a fundamental residual current in a main circuit are restored to process a large residual current signal of above 0.1A. Therefore, the accuracy of the residual current of sampling can be improved, the large and small residual currents can be processed, and the use of the hardware circuit can also be reduced.

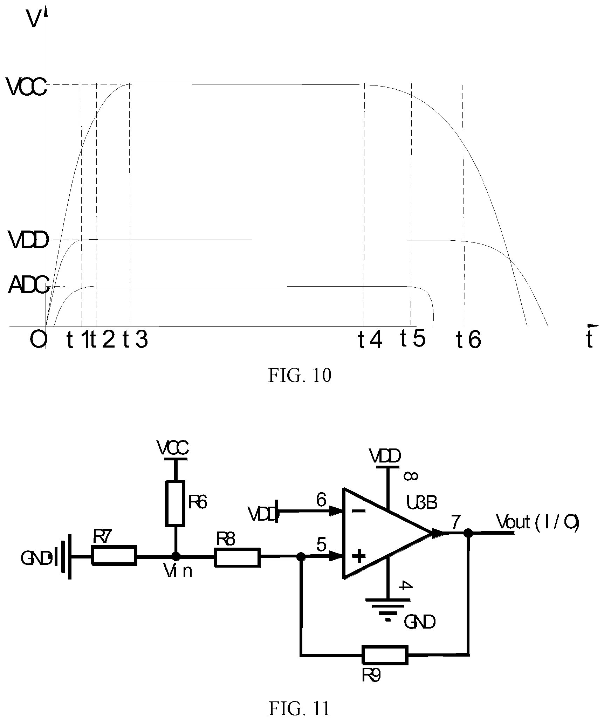

As shown in FIG. 1, the residual current operated circuit breaker of the present embodiment includes a power supply circuit, a sampling circuit and a main control circuit 120. The power supply circuit supplies power to the sampling circuit and the main control circuit 120. The main control circuit 120 collects a residual current of the main circuit of the circuit breaker through the sampling circuit. When the residual current is detected, the main control circuit 120 outputs a tripping control signal to a tripping circuit, triggers an operating mechanism to trip, and then makes the residual current operated circuit breaker disconnected. The sampling circuit in the present embodiment includes an excitation oscillation circuit 109, an integrating circuit 110, a filtering and amplification circuit 112 and a zeroing circuit 113 that are connected sequentially. The power supply circuit includes a rectifying circuit 102, and a first BUCK circuit 104 and a second BUCK circuit 106 that are connected to the rectifying circuit 102 through the BUCK circuit respectively. The residual current operated circuit breaker of the present embodiment is a full-type residual current protection device with monitoring protection such as AC, pulsating DC, smooth DC, composite current, high-frequency current, etc. As shown in FIG. 1, the power supply circuit includes a rectifying circuit 102, a first BUCK circuit 104 and a second BUCK circuit 106 that are connected to the rectifying circuit 102 through the BUCK circuit respectively. The first BUCK circuit 104 is used for supplying a voltage VCC and a reference voltage Vref for the sampling circuit. The second BUCK circuit 106 is used for supplying a voltage VDD for the main control circuit 120. The voltage VCC is greater than the voltage VDD. In the present embodiment, the voltage VCC is 12V, and the voltage VDD is 3.3V. The first BUCK circuit 104 is also used for generating a reference voltage Vref. As shown in FIG. 10, because the voltage VCC is greater than the voltage VDD, during the power-on process, the voltage VDD will be more stable first than the voltage VCC. The main control circuit 120 may start sampling through the sampling circuit when the voltage VCC is unstable. During the power-down process, the voltage VCC may also be powered down first, which also causes the sampling circuit to be unstable, and then causes the product to malfunction. Because the excitation oscillation circuit 109 is supplied with a voltage of 12V, and a voltage of 3.3V is supplied by MCU sampling here. During the power-on process, the voltage of 3.3V is stable first and then the voltage of 12V is stable. Therefore, the excitation oscillation circuit cannot work normally when the MCU starts to carry out ADC sampling, so that the ADC cannot collect data accurately, resulting in the trigger of tripping. During a power-down process, the voltage of 12V drops first, and the voltage of 3.3V is still stable, which will also cause the ADC sampling to be inaccurate, resulting in the trigger of tripping.

Preferably, the residual current operated circuit breaker of the present invention further includes a power supply monitoring circuit 122 connected to the main control circuit 120. The power supply monitoring circuit 122 respectively collects the voltage VCC and the voltage VDD and is used for detecting whether the power supply VCC is stable. A monitoring signal outputted by the power supply monitoring circuit 122 can make the main control circuit 120 unable to output a tripping signal. This power supply monitoring circuit monitors the voltage VCC, which powers the sampling circuit, and the voltage VDD, which powers the main control circuit, outputting a monitoring signal to the main control circuit. The main control circuit can only drive the residual current operated circuit breaker to disconnect when the voltage VCC is stable and the residual current magnitude and duration meet the action criteria. Therefore, during the power-on and power-down processes, the instability in the residual current sampling of the main control circuit caused by the instability of the voltage VCC is prevented, which in turn prevents the main control circuit from accidentally triggering the product action.

Preferably, the power supply circuit further includes a DC-DC BUCK circuit 105. The DC-DC BUCK circuit 105 includes a BUCK chip U2 connected between the second BUCK circuit 106 and the rectifying circuit 102. The model of the BUCK chip U2 is LA1631. The rectifying circuit 102 includes a rectifying bridge for rectifying a single-phase or three-phase input current into a pulsating DC power supply, as an input of a later-stage BUCK circuit 103. The BUCK circuit 103 is used for carrying out BUCK processing on the rectified pulsating DC power supply to obtain a low-voltage DC power supply. The first BUCK circuit 104 and the second BUCK circuit 106 are linear BUCK circuits, respectively. The first BUCK circuit 104 is used for carrying out linear BUCK processing on a low-voltage DC voltage outputted by the BUCK circuit 103 to become a smooth low-voltage DC voltage VCC and a reference power supply Vref, wherein Vref=VCC/2.

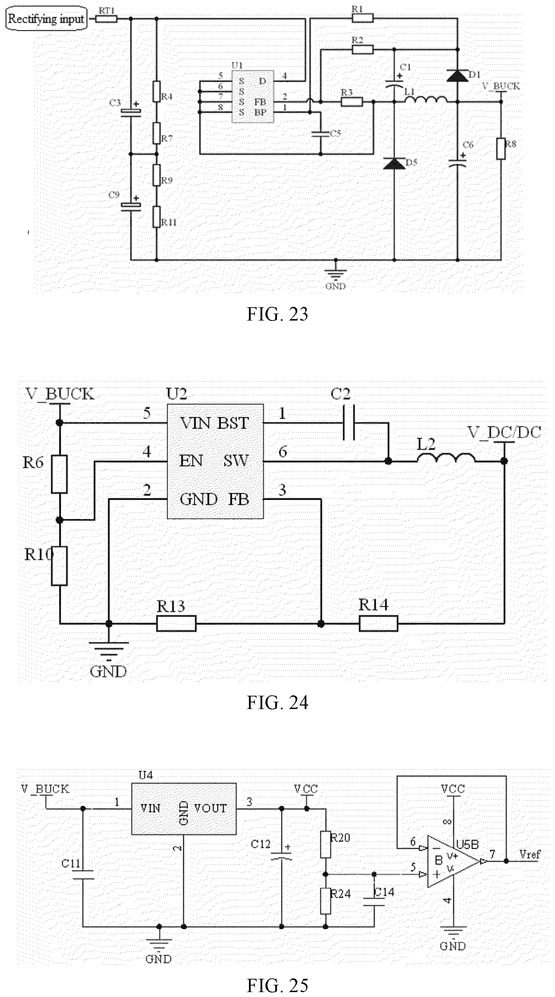

As shown in FIG. 25, a circuit diagram of the first BUCK circuit 104 is shown. The first BUCK circuit 104 includes a linear BUCK chip U4. The linear BUCK chip U4 is a special fixed-value BUCK chip. The model of the linear BUCK chip U4 is MC78M12ABDTRKG. An input terminal of the linear BUCK chip U4 is connected to the BUCK circuit 103, and an output terminal of the linear BUCK chip U4 is used for outputting the voltage VCC that is subjected to BUCK processing. The output terminal of the linear BUCK chip U4 is connected to an input terminal of an operational amplifier U5B after voltage division by a resistor R20 and a resistor R24 which have the same resistance value. An output reference voltage Vref is followed by an output terminal of the operational amplifier U5B.

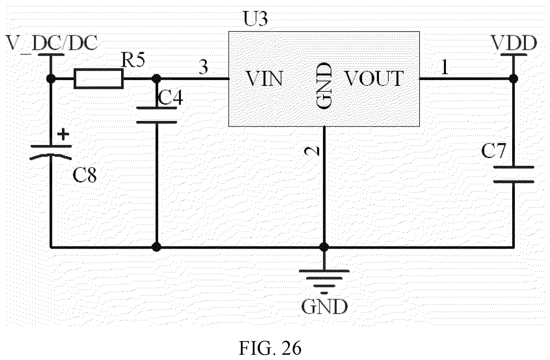

As shown in FIG. 26, a circuit diagram of the second BUCK circuit 106 is shown. The second BUCK circuit 106 includes a linear BUCK chip U3. The linear BUCK chip U3 is a special fixed-value BUCK chip. The model of the linear BUCK chip U3 is SGM2205. An input terminal of the linear BUCK chip U3 is connected to the DC-DC BUCK circuit 105 through a resistor R5, and an output terminal of the linear BUCK chip U3 is used for generating a voltage VDD so as to supply power to the main control circuit 120. Both ends of the resistor R5 are grounded through a capacitor C4 and a capacitor C8, respectively. The output terminal of the linear BUCK chip U3 is grounded through a capacitor C7.

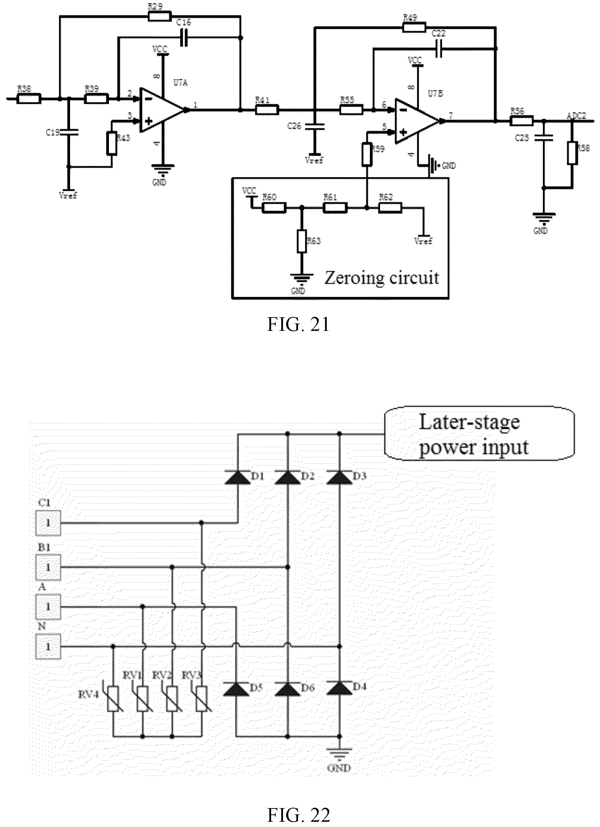

As shown in FIG. 21, a circuit diagram of the rectifying circuit 102 is shown. The rectifying circuit 102 includes a surge protection circuit and a rectifying portion, and has any three-phase and four-wire wiring, without distinguishing the characteristics of A, B, C and N. The surge protection circuit is composed of a varistor RV1, a varistor RV2, a varistor RV3 and a varistor RV4. One ends of the varistor RV4, the varistor RV1, the varistor RV2, the varistor RV3 and the varistor RV4 are connected to a first power line, a second power line, a third power supply line and a fourth power line, respectively, and the other ends of the varistor RV1, the varistor RV2, the varistor RV3 and the varistor RV4 are connected each other and connected to a common point. This common point is not connected to other circuits. In the normal power supply process, there are two varistors connected in series between any two phases, thereby increasing a rated service voltage of the product. At the same time, the same nominal voltage specification can be used for the four varistors, which, in the presence of a surge voltage impulse, lower than a residual voltage of a mode in which a varistor having higher nominal voltage is adopted to connect A, B and C to N, thereby reducing the design requirements of a later-stage circuit.

The rectifying portion includes rectifying diodes D1, D2, D3, D4, D5 and D6. The first power line is connected to an anode of the diode D1. The second power line is connected to an anode of the diode D2 and a cathode of the diode D6. The third power line is connected to a cathode of the diode D5. The fourth power line is connected to an anode of the diode D3 and a cathode of the diode D4. Further, cathodes of the diodes D1, D2 and D3 are connected to an input of a later-stage power supply, and anodes of the diodes D4, D5 and D6 are connected to a floating ground of the later-stage power supply.

As shown in FIG. 22, the BUCK circuit 103 includes a power supply chip U1. The power supply chip U1 is a dedicated BUCK chip. The model of the power supply chip U1 is LNK3296, and an MOS switch tube of 800 V and higher is built in the power supply chip U1 and can reduce a voltage passing through the rectifying circuit 102 to a usable low voltage of 12-24V. The input terminal of the power supply chip U1 is connected to the rectifying circuit 102 through a resistor RT1. The resistor RT1 forms an RC filtering circuit together with a capacitor C3 and a capacitor C9 which are connected in series. The capacitor C3 and the capacitor C9 are connected in series to improve the overall withstand voltage. A resistor R4 and a resistor R7 are connected in series and then in parallel to both ends of the capacitor C3, and a resistor R9 and a resistor R11 are connected in series and then in parallel to both ends of the capacitor C9. The resistor R4, the resistor R7, the resistor R9 and the resistor R11 are used as equalizing resistors to evenly distribute the voltages at both ends of the capacitor C3 and the capacitor C9.

The DC-DC BUCK circuit 105 is also used for carrying out linear BUCK processing on a low-voltage DC voltage outputted from the BUCK circuit 103, thereby improving the conversion efficiency of the power supply. An output voltage of the DC-DC BUCK circuit 105 is subjected to linear BUCK processing through the second BUCK circuit 106 to become a smooth low-voltage DC voltage VDD. The produced voltage VDD is used for supplying power to the main control circuit 120 and related circuits.

It may be understood that the DC-DC BUCK circuit 105 may also be not arranged, and a voltage VDD may also be directly obtained through the second BUCK circuit 106, both of which fall within the protection scope of the present invention.

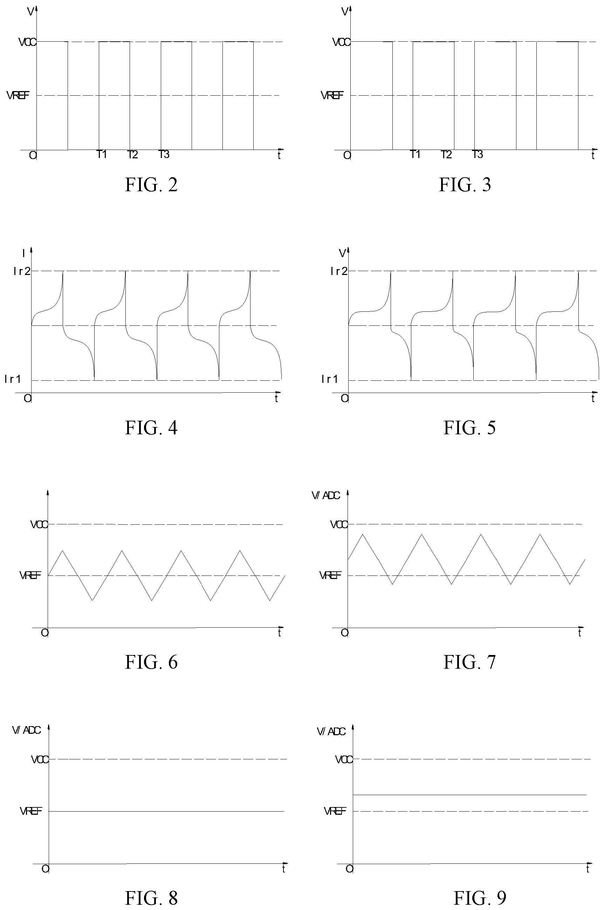

As shown in FIGS. 2-5, the excitation oscillation circuit 109 forms RL self-excited oscillation based on the characteristics of a nonlinear magnetization curve of a ferromagnetic material. The excitation oscillation circuit 109 includes a square wave impulse voltage driving circuit and a comparison circuit. The square wave impulse voltage driving circuit and the comparison circuit are connected to an excitation winding 107 of the residual current transformer, and used for forming cyclic self-excited oscillation. A square wave excitation voltage is applied to both ends of the excitation winding 107 of the residual current transformer through the excitation oscillation circuit 109, as shown in FIG. 2. A direction of an excitation current flowing through the excitation winding 107 of the residual current transformer is changed cyclically. As shown in FIG. 4, a magnetic core 101 of the residual current transformer is transformed between positive saturation and negative saturation.

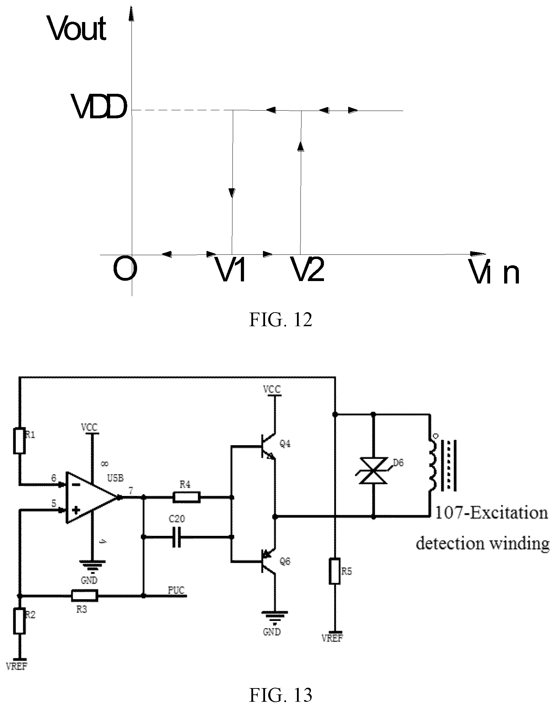

When there is a residual current in the main circuit, the DC residual current is used as an example: the magnetic core 101 of the residual current transformer will produce a bias in one direction, and then enter a magnetically saturated state in advance in this direction, such that the corresponding excitation square wave duty cycle will be narrowed. Correspondingly, the magnetic core 101 of the residual current transformer may delay and enter into saturation in another direction, and the corresponding square wave excitation voltage duty cycle will be widened, as shown in FIG. 3. At the same time, the current in the excitation winding 107 of the residual current transformer may also produce a corresponding change, as shown in FIG. 5. At the same time, the VCC is greater than the VDD, so as to provide a larger excitation current. As shown in FIGS. 13-14, two embodiments of the excitation oscillation circuit 109 are respectively shown, and both fall within the protection scope of the present invention.

As shown in FIGS. 6-7, the integrating circuit 110 is used for transforming an excitation square wave signal generated by the excitation oscillation circuit 109 into a triangular wave signal. As shown in FIG. 6 and FIG. 7, the triangular wave signal, acting as a carrier signal for the residual current in the main circuit that passes through the magnetic core 101 of the residual current transformer, can reflect the variation characteristics of the fundamental residual current in the main circuit, including the magnitude and direction of the fundamental residual current in the main circuit.

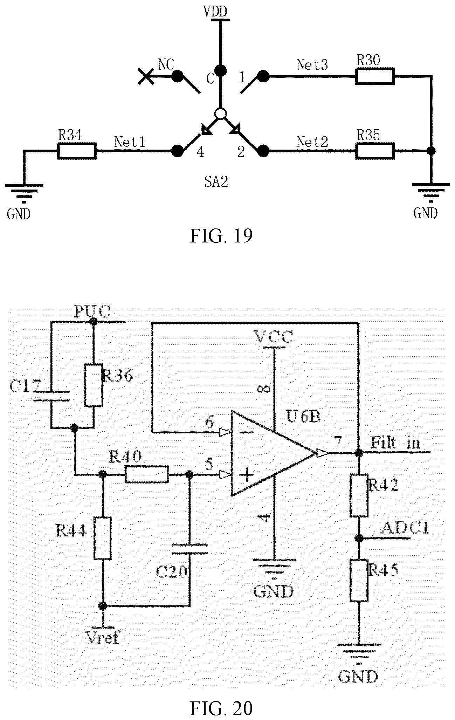

As shown in FIG. 19, the integrating circuit 110 includes an operational amplifier U6B, and a high-pass filtering circuit and an RC integrating circuit that are respectively connected to an input terminal of the operational amplifier U6B. An output terminal of the operational amplifier U6B is connected to the filtering and amplification circuit 112 and the main control circuit 120, respectively. The high-pass filtering circuit is connected to the excitation oscillation circuit 109. The high-pass filtering circuit is used for filtering a duty cycle signal outputted from the excitation oscillation circuit 109. The RC integrating circuit is used for transforming the filtered signal into a triangular wave signal. The operational amplifier U6B is used as a voltage follower to increase a later-stage driving capability of the triangular wave signal at a non-inverting input terminal.

Specifically, the duty cycle signal outputted from the excitation oscillation circuit 109 enters the integrating circuit 110 and is filtered through a high-pass filtering circuit composed of a resistor R36 and a capacitor C17, and then transformed into a triangle wave signal through an RC integrating circuit composed of a resistor R40 and a capacitor C20. The operational amplifier U6B is used as a voltage follower in the circuit to increase a later-stage driving capacity of the triangle wave signal at the non-inverting input terminal. An output signal of the first output terminal outputted from the operational amplifier U6B enters the next-level hardware filtering and amplification circuit 112. An output signal of the second output terminal outputted from the operational amplifier U6B is subjected to voltage division through a resistor and directly enters an ADC port of the main control circuit 120.

As shown in FIGS. 8-9, the filtering and amplification circuit 112 is used for performing filtering and amplification processing to filter out carrier components of the triangle wave, and restoring the characteristics of the residual current in the main circuit.

As shown in FIG. 1, a zeroing circuit is further included. The filtering and amplification circuit 112 is connected to the main control circuit 120 through the zeroing circuit. The zeroed signal collected by the main control circuit 120 can be directly calculated for a valid value. The zeroing circuit is used for adjusting an input of a smaller residual current channel. When the signal passes through the filtering and amplification circuit 112, the zero drift of the signal will be further amplified. The ADC input is caused to be within a zero point error range through the zeroing circuit, which can effectively improve the action accuracy of the product. Of course, the zeroing circuit may also be not arranged, and the filtering and amplification circuit 112 is directly connected to the main control circuit 120, both of which fall within the protection scope of the present invention.

As shown in FIG. 20, the filtering and amplification circuit 112 includes a fourth-order filtering circuit consisting of two second-order Butterworth active filtering circuits which are connected in series. The fourth-order filtering circuit can perform better attenuation on the carrier signal of excitation.

Further, the filtering and amplification circuit 112 further includes a zeroing circuit 113. The two second-order Butterworth active filtering circuits both include an operational amplifier, wherein the operational amplifier of one of the second-order Butterworth active filtering circuits is connected to the zeroing circuit 113. The zeroing circuit 113 is used for adjusting a voltage at a non-inverting input terminal of the operational amplifier in the second-order Butterworth active filter circuit.

Specifically, the operational amplifier of the second-order Butterworth active filtering circuit connected to the zeroing circuit 113 is an operational amplifier U7B. According to a resistance divider principle, the zeroing circuit 113 includes a resistor R60 and a resistor R63 connected between the voltage VCC and a grounding terminal. The resistor R60 and the resistor R63 are connected in series. A connection point between the resistor R60 and the resistor R63 is connected to a non-inverting input terminal of the operational amplifier U7B. A voltage of the non-inverting input terminal of the operational amplifier U7B corresponding to the Butterworth active filtering circuit can be adjusted according to the resistance values of the resistor R60 and the resistor R63 of the zeroing circuit 113, thereby completing the output voltage adjustment of the operational amplifier U7B, and then the zero adjustment of the entire circuit.

Preferably, the main control circuit 120 performs FIR or Kalman digital filtering on a second output terminal. An FIR filter may be adopted for FIR filtering, and a Kalman filter may be adopted for Kalman filtering. Of course, other digital filtering methods may also be used, all of which fall within the protection scope of the present invention.

As shown in FIG. 11, the power supply monitoring circuit 122 in the present embodiment is a hysteresis comparison circuit. The hysteresis comparison circuit is used for comparing a power supply Vin obtained by voltage division of a voltage VCC with a voltage VDD, and outputting a low level to the main control circuit 120 when the power supply Vin is less than the voltage VDD, such that the main control circuit 120 cannot output a tripping signal, and output a high level to the main control circuit 120 when the power supply Vin is greater than the voltage VDD. The input power supply Vin of the comparator U3B is obtained after voltage division by a resistor R6 and a resistor R7. The comparator U3B indicates that the voltage VCC is stable when the power supply Vin is greater than the voltage VDD. A high level is outputted to the main control circuit 120. The main control circuit 120 enables the main control circuit 120 to disconnect the residual current operated circuit breaker when the magnitude and duration of the residual current satisfy action conditions, and on the contrary, the comparator U3B outputs a low level. The main control circuit 120 cannot output a tripping signal to disconnect the residual current operated circuit breaker.

As shown in FIG. 12, during the power-on process, when the power supply Vin rises to V2, the comparator U3B will output a high level, and the main control circuit 120 will not trigger the product action before the high level is outputted. During the power-down process, when the power supply Vin drops to V1, the comparator U3B outputs a low level, and the main control circuit 120 will not trigger the product action.

Specifically, the power supply monitoring circuit 122 in the present embodiment includes a comparator U3B. An output terminal of the comparator U3B is connected to the main control circuit 120. An inverting input terminal of the comparator U3B is connected to the voltage VDD, and a non-inverting input terminal of the comparator U3B is connected to nodes constituting the power supply Vin through a resistor R8. The nodes constituting the power supply Vin are connected to a voltage VCC and a ground terminal through a resistor R6 and a resistor R7, respectively.

Further, the sampling circuit includes an excitation oscillation circuit 109, an integrating circuit 110, a filtering and amplification circuit 112 and a zeroing circuit 113 that are connected sequentially. The excitation oscillation circuit 109 is connected to the excitation winding 107 on the residual current transformer.

The excitation oscillation circuit 109 forms RL self-excited oscillation based on a nonlinear magnetization curve characteristic of a ferromagnetic material. The excitation oscillation circuit 109 includes a square wave impulse voltage driving circuit and a comparison circuit. The excitation winding 107 of the residual current transformer, the square wave impulse voltage driving circuit and the comparator form cyclic self-excited oscillation. A square wave excitation voltage is applied to both ends of the excitation winding 107 of the residual current transformer. The integrating circuit 110 is used for transforming an excitation square wave signal produced by the excitation oscillation circuit 109 into a triangular wave signal. This triangular wave signal is used as a carrier signal of the residual current in the main circuit of the magnetic core 101 of the residual current transformer, and can reflect the fundamental residual current change characteristics in this main circuit, including a magnitude and direction of the fundamental residual current in the main circuit. The filtering and amplification circuit 112 is used for performing filtering and amplification processing to filter out carrier components of a triangle wave, and the characteristics of the residual current in the main circuit are restored. The zeroing circuit is used for adjusting an input of a smaller residual current channel. When the signal passes through the filtering and amplification circuit 112, the zero drift of the signal will be further amplified, and the ADC input is caused to be within the zeroing point error range through the zeroing circuit, thereby effectively improving the action accuracy of the product. Of course, the zeroing circuit may also be not arranged, and the filtering and amplification circuit 112 is directly connected to the main control circuit 120, both of which fall within the protection scope of the present invention.

It may be understood that the sampling circuit may also use other prior art to collect leakage signals, all of which belong to the protection scope of the present invention. As shown in FIGS. 13-14, two embodiments of the excitation oscillation circuit 109 are respectively shown, and both fall within the protection scope of the present invention.

As shown in the embodiment of FIG. 13, the excitation oscillation circuit 109 includes a comparator U5B, an NPN triode Q4 and a PNP triode Q6. A collector of the NPN triode Q4 is connected to the voltage VCC, and an emitter of the NPN triode Q4 is connected to an emitter of the PNP triode Q6. A collector of the PNP triode Q6 is grounded. A connection point between the emitter of the NPN triode Q4 and the emitter of the PNP triode Q6 is connected to one end of the excitation winding 107 on the residual current transformer. An inverting input terminal of the comparator U5B is connected to a reference voltage Vref through a resistor R1 and a resistor R5. A connection point between the resistor R1 and the resistor R5 is connected to the other end of the excitation winding 107. A bidirectional voltage regulator diode D6 is connected in parallel to both ends of the excitation winding 107. A positive input terminal of the comparator U5B is connected to the reference voltage Vref through a resistor R2. One end of the resistor R4 connected in parallel to the capacitor C20 is connected in parallel to the output terminal of the comparator U5B, and the other end of the resistor R4 is connected to a base of the NPN triode Q4 and a base of the PNP transistor Q6. The output terminal of the comparator U5B is connected to the positive input terminal of the comparator U5B through a resistor R3, and is outputted to the main control circuit 120.

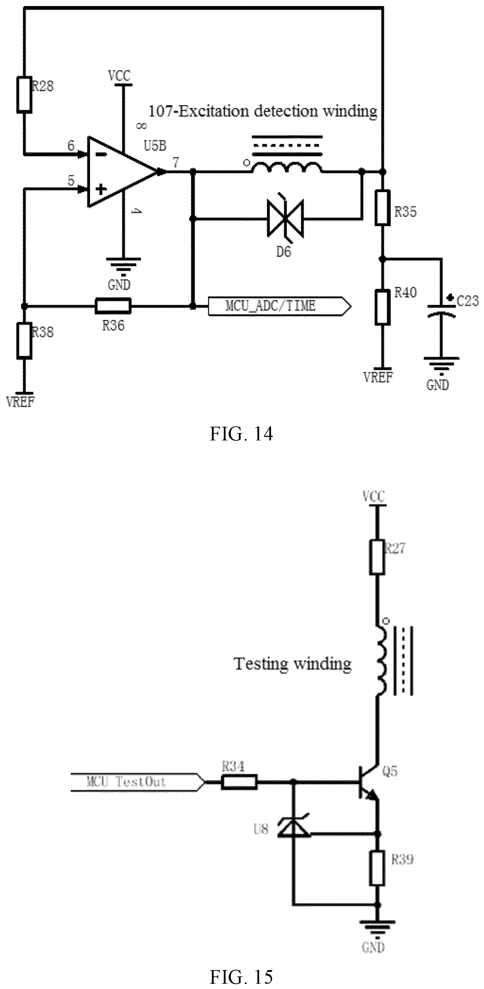

As shown in the embodiment shown in FIG. 14, the excitation oscillation circuit 109 includes a comparator U5B. An output terminal of the comparator U5B is connected to one end of the excitation winding 107 on the residual current transformer. An inverting input terminal of the comparator U5B is connected to the reference voltage Vref through a resistor R28, a resistor R35 and a resistor R40. The other end of the excitation winding 107 is connected between the resistor R28 and the resistor R35. A positive input terminal of the comparator U5B is connected to the reference voltage Vref through a resistor R38, and an output terminal of the comparator U5B is connected to the positive input terminal of the comparator U5B through a resistor R36, and outputted to the main control circuit 120. The bidirectional voltage regulator diode D6 is connected in parallel to both ends of the excitation winding 107. One end of the capacitor C23 is grounded, and the other end of the capacitor C23 is connected between the resistor R35 and the resistor R40.

As shown in FIG. 1, a residual current gear selection circuit 117 and a delay gear selection circuit 118 are included. The residual current gear selection circuit 117 and the delay gear selection circuit 118 are respectively used for setting an action threshold of the magnitude of the residual current and a delay threshold of the duration. The residual current gear selection circuit 117 is used for outputting a plurality of different signals to the main control circuit 120 to set the action threshold of the magnitude of the residual current. The delay gear selection circuit 118 is used for outputting a plurality of different signals to the main control circuit 120 to set the delay threshold of the residual current. When the magnitude of the residual current detected by the main control circuit 120 through the sampling circuit reaches the action threshold selected by the residual current gear selection circuit 117, the main control circuit 120 starts timing. If the duration reaches a delay threshold selected by the delay gear selection circuit 118, the main control circuit 120 trips the operating mechanism through the tripping circuit, and then the residual current operated circuit breaker is disconnected.

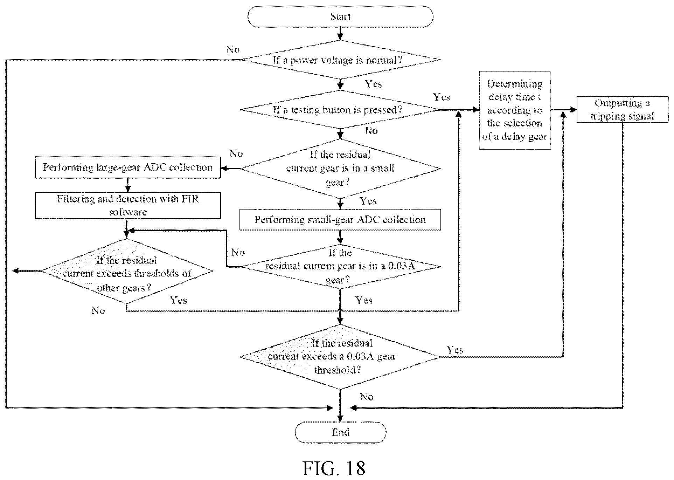

As shown in FIG. 18, the residual current gear selection circuit 117 and the delay gear selection circuit 118 are the same. The residual current gear selection circuit 117 and the delay gear selection circuit 118 include a rotary coding switch SA1 and a plurality of resistors, respectively. Different resistors are turned on by rotating the rotary coding switch SA1, and further the main control circuit 120 can determine a gear of the rotary coding switch by detecting high and low level changes of a Net1 node, a Net2 node and a Net3 node. The second BUCK circuit also provides a voltage VDD for the residual current gear selection circuit 117 and the delay gear selection circuit 118 at the same time. The voltage VDD is connected to the main control circuit 120 through the rotary coding switch SA1 and the plurality of resistors with different resistance values.

The rotary coding switch SA1 in the present embodiment can generate five power-on states through the rotation of three pin contacts, and can be further set to action thresholds or delay gear states of five residual current magnitudes. The residual current gear selection circuit 117 in the present embodiment includes 0.03A, 0.1A, 0.5A, 1A and 2A gears, and the delay gear selection circuit 118 includes 0s, 0.1s, 0.3s, 0.5s and 2s gears. The main control circuit 120 determines a gear of the rotary coding switch by detecting combination changes of high and low levels of the Net1 node, the Net2 node and the Net3 node. The main control circuit 120 collects the residual current of the main circuit of the circuit breaker through the sampling circuit. When the magnitude of the residual current is greater than the action threshold and the duration reaches the delay threshold, a tripping signal is emitted, and the residual current operated circuit breaker is disconnected.

In another embodiment, the residual current gear selection circuit 117 and the delay gear selection circuit 118 include a knob-type variable resistor, respectively; a resistance value of the knob-type variable resistor is adjusted by means of rotation; and voltage signals of different voltage values are outputted to the main control circuit 120. For example, one end of the knob-type variable resistor of the residual current gear selection circuit 117 is connected to a 3V power supply, and the other end of the knob-type variable resistor is connected to the main control circuit 120. A voltage value is changed by rotating the knob-type variable resistor to different gears to change resistance values. Then, voltages of less than 0.1V, 0.1V, 0.5V, 1V and 2V are outputted to indicate 03A, 0.1A, 0.5A, 1A and 2A gears, respectively.

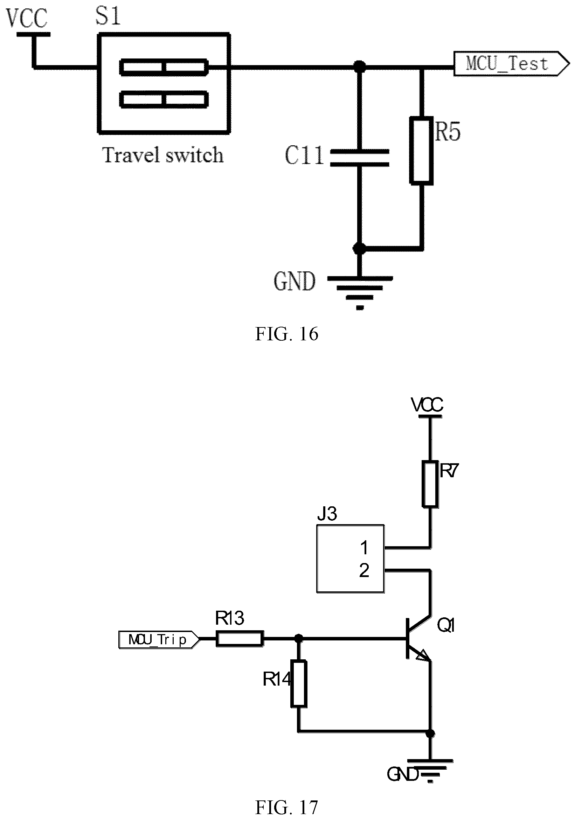

As shown in FIG. 1, the residual current operated circuit breaker further includes a tripping circuit. The tripping circuit in the present embodiment includes a tripping control circuit 115 (FIG. 17) connected to the main control circuit 120, and a tripping unit 116 matched with the tripping control circuit 115. The main control circuit 120 can drive the tripping unit 116 to act through the tripping control circuit 115. The tripping unit 116 can drive the operating mechanism to trip when the tripping unit 116 acts, and the residual current operated circuit breaker is driven by the operating mechanism to be disconnected.

As shown in FIG. 1, a testing circuit is further included. The testing circuit in the present embodiment includes a leakage testing circuit 121, a residual current simulation circuit 114 and a testing winding 108 wound around the magnetic core 101 of the residual current transformer. The leakage testing circuit 121 is used for detecting whether a testing key is pressed. The leakage testing circuit 121 can enable the residual current simulation circuit 114 to simulate a residual current when the testing key is pressed, simulate a residual current fault, and test whether the residual current operated circuit breaker is disconnected.

As shown in FIG. 1, an indication circuit 119 is further included. The indication circuit 119 includes at least two light-emitting elements as an operation indicator and a fault indicator of the circuit.

The main control circuit 120 in the present embodiment is an MCU. When the main control circuit 120 first determines that the voltage VCC is stable through the power supply monitoring circuit 122, and detects that the testing key is not pressed, whether a gear selected by the residual current gear selection circuit 117 is a large gear or a small gear begins to be determined, and a leakage signal of a first output terminal or a second output terminal corresponding to this gear is collected. When the magnitude of the residual current of this output terminal reaches an action threshold set by this gear, the main control circuit 120 starts timing and determine what is the delay threshold t selected by the delay gear selection circuit 118. When a leakage duration reaches the delay threshold t, a tripping signal is outputted to the tripping circuit, and the residual current operated circuit breaker is disconnected. If the residual current gear selection circuit 117 selects a smallest gear (0.03A in the present embodiment), the main control circuit 120 skips the determination of the delay threshold and directly outputs the tripping signal.

As shown in FIG. 16, a key detection circuit is further included. The key detection circuit is connected to the main control circuit 120 through a MCU_Test pin. FIG. 15 also shows a residual current simulation circuit 114. The residual current simulation circuit 114 is connected to the main control circuit 120 through a MCU_TestOut pin. When the main control circuit 120 detects that a key S1 that is used as a product debugging button in FIG. 16 is pressed, the MCU_Test pin is a high level, the MCU_Testout pin can emit a PWM wave signal with a duty cycle is 1:1, and then a switch tube Q5 will be opened intermittently. A current will generate a simulated residual current in the testing winding 108 after passing through a resistor R27, a testing winding 108 and a resistor R39. The simulated residual current will be detected by the detection winding 107 and then trigger the product to trip.

We have made further detailed description of the present invention mentioned above in combination with specific preferred embodiments, but it is not deemed that the specific embodiments of the present invention is only limited to these descriptions. A person skilled in the art can also, without departing from the concept of the present invention, make several simple deductions or substitutions, which all be deemed to fall within the protection scope of the present invention.

## Claims

1. A residual current operated circuit breaker, comprising a power supply circuit, a sampling circuit and a main control circuit (120), the power supply circuit supplies power to the sampling circuit and the main control circuit (120); the main control circuit (120) collects a residual current of a main circuit of the circuit breaker through the sampling circuit; wherein the sampling circuit comprises an excitation oscillation circuit (109) and an integrating circuit (110); the excitation oscillation circuit (109) is connected to an excitation winding (107) on the residual current transformer; the integrating circuit (110) is used for transforming an excitation square wave signal produced by the excitation oscillation circuit (109) into a triangular wave signal and then outputting the triangular wave signal respectively through a first output terminal and a second output terminal; the first output terminal is connected to the main control circuit (120) through a filtering and amplification circuit (112); the second output terminal is directly connected to the main control circuit (120); and the main control circuit (120) collects a residual current of the filter and amplification circuit (112) and/or the second output terminal respectively, and used for controlling the residual current operated circuit breaker to be disconnected.

2. The residual current operated circuit breaker according to claim 1, further comprising a residual current gear selection circuit (117) and a delay gear selection circuit (118) which are respectively connected to the main control circuit (120), the residual current gear selection circuit (117) is used for outputting a plurality of different signals to the main control circuit (120) to set an action threshold of the magnitude of the residual current; and the delay gear selection circuit (118) is used for outputting a plurality of different signals to the main control circuit (120) to set a delay threshold of the residual current.

3. The residual current operated circuit breaker according to claim 1, wherein the main control circuit (120) performs FIR or Kalman digital filtering processing on the second output terminal.

4. The residual current operated circuit breaker according to claim 1, wherein the integrating circuit (110) comprises an operational amplifier U6B, and a high-pass filtering circuit and an RC integrating circuit that are respectively connected to an input terminal of the operational amplifier U6B; an output terminal of the operational amplifier U6B is connected to the filtering and amplification circuit (112) and the main control circuit (120), respectively; the high-pass filtering circuit is connected to the excitation oscillation circuit (109); the high-pass filtering circuit is used for filtering a duty cycle signal outputted from the excitation oscillation circuit (109); the RC integrating circuit is used for transforming the filtered signal into a triangular wave signal; and the operational amplifier U6B is used as a voltage follower to increase a later-stage driving capability of a triangular wave signal at a non-inverting input terminal.

5. The residual current operated circuit breaker according to claim 1, wherein the excitation oscillation circuit (109) includes a square wave impulse voltage driving circuit and a comparison circuit; and the square wave impulse voltage driving circuit and the comparison circuit are connected to an excitation winding (107) on the residual current transformer, and used for forming cyclic self-excited oscillation.

6. The residual current operated circuit breaker according to claim 1, wherein the filtering and amplification circuit (112) comprises a fourth-order filtering circuit consisting of two second-order Butterworth active filtering circuits which are connected in series.

7. The residual current operated circuit breaker according to claim 6, further comprising a zeroing circuit connected to the filtering and amplification circuit (112).

8. The residual current operated circuit breaker according to claim 6, wherein the two second-order Butterworth active filtering circuits both include an operational amplifier, wherein the operational amplifier of one of the second-order Butterworth active filtering circuits is connected to an zeroing circuit (113); the zeroing circuit (113) comprises a resistor R60 and a resistor R63 connected between a voltage VCC and a grounding terminal; the resistor R60 and the resistor R63 are connected in series; and a connection point between the resistor R60 and the resistor R63 is connected to a non-inverting input terminal of the operational amplifier of the second-order Butterworth active filter circuit.

9. The residual current operated circuit breaker according to claim 1, wherein the excitation oscillation circuit (109) comprises a comparator U5B, an NPN triode Q4 and a PNP triode Q6; a collector of the NPN triode Q4 is connected to the voltage VCC, and an emitter of the NPN triode Q4 is connected to an emitter of the PNP triode Q6; a collector of the PNP triode Q6 is grounded; a connection point between the emitter of the NPN triode Q4 and the emitter of the PNP triode Q6 is connected to one end of the excitation winding (107) on the residual current transformer; an inverting input terminal of the comparator U5B is connected to a reference voltage Vref through a resistor R1 and a resistor R5; a connection point between the resistor R1 and the resistor R5 is connected to the other end of the excitation winding (107); a bidirectional voltage regulator diode D6 is connected in parallel to both ends of the excitation winding (107); a positive input terminal of the comparator U5B is connected to the reference voltage Vref through a resistor R2; one end of the resistor R4 connected in parallel to the capacitor C20 is connected in parallel to the output terminal of the comparator U5B, and the other end of the resistor R4 is connected to a base of the NPN triode Q4 and a base of the PNP transistor Q6; the output terminal of the comparator U5B is connected to the positive input terminal of the comparator U5B through a resistor R3, and is outputted to the main control circuit (120).

10. The residual current operated circuit breaker according to claim 1, wherein the excitation oscillation circuit (109) comprises a comparator U5B; an output terminal of the comparator U5B is connected to one end of the excitation winding (107) on the residual current transformer; an inverting input terminal of the comparator U5B is connected to a reference voltage Vref through a resistor R28, a resistor R35 and a resistor R40, and the other end of the excitation winding (107) is connected between the resistor R28 and the resistor R35; a positive input terminal of the comparator U5B is connected to the reference voltage Vref through a resistor R38; an output terminal of the comparator U5B is connected to a positive input terminal of the comparator U5B through a resistor R36, and outputted to the main control circuit (120); the bidirectional voltage regulator diode D6 is connected in parallel to both ends of the excitation winding (107); and one end of the capacitor C23 is grounded, and the other end of the capacitor C23 is connected between the resistor R35 and the resistor R40.

11. The residual current operated circuit breaker according to claim 1, wherein the power supply circuit comprises a first BUCK circuit (104) and a second BUCK circuit (106); the first BUCK circuit (104) is used for supplying a voltage VCC to a sampling circuit; the second BUCK circuit (106) is used for supplying a voltage VDD to the main control circuit (120); the voltage VCC is greater than the voltage VDD; the residual current operated circuit breaker further comprises a power supply monitoring circuit (122) connected to the main control circuit (120); and the power supply monitoring circuit (122) monitors the voltage VCC used for supplying power to the sampling circuit and the voltage VDD used for supplying power to the main control circuit, and the power supply monitoring circuit (122) outputs a monitoring signal to the main control circuit.

12. The residual current operated circuit breaker according to claim 11, wherein the power supply monitoring circuit (122) comprises a hysteresis comparison circuit, the hysteresis comparison circuit is used for comparing a power supply Vin obtained by voltage division of a voltage VCC with a voltage VDD, and outputting a low level to the main control circuit (120) when the power supply Vin is less than the voltage VDD, such that the main control circuit (120) cannot output a tripping signal, and output a high level to the main control circuit (120) when the power supply Vin is greater than the voltage VDD.

13. The residual current operated circuit breaker according to claim 12, wherein the power supply monitoring circuit (122) comprises a comparator U3B; an output terminal of the comparator U3B is connected to the main control circuit (120); an inverting input terminal of the comparator U3B is connected to the voltage VDD, and a non-inverting input terminal of the comparator U3B is connected to nodes constituting the power supply Vin through a resistor R8; and the nodes constituting the power supply Vin are connected to the voltage VCC and the ground terminal through a resistor R6 and a resistor R7, respectively.
